# EUROPEAN PATENT APPLICATION

(11) **EP 4 297 180 A1**
(43) Date of publication of application: **27.12.2023**
(21) Application number: 22756171.9
(22) Date of filing: 15.02.2022
(51) Int. Cl.: H01P 3/12, H01Q 1/38, H01Q 13/02, H05K 1/02, H05K 1/11, H05K 3/46

(54) **PRINTED WIRING BOARD**

(30) Priority: 22.02.2021 JP 2021025777
(71) Applicant: Kyocera Corporation, Kyoto-shi Kyoto 612-8501 (JP)
(72) Inventor: NAGASE, Tomoya, Kyoto-shi, Kyoto 612-8501 (JP); SHIMADA, Nobuhiro, Kyoto-shi, Kyoto 612-8501 (JP)
(74) Representative: Viering, Jentschura & Partner mbB Patent- und Rechtsanwälte
(86) International application number: PCT/JP2022/005952
(87) International publication number: WO 2022/176853

(57) **Abstract**

A printed wiring board includes a first insulating layer and a through-hole conductor. The first insulating layer includes a through-hole passing through from a first surface of the first insulating layer to a second surface opposite the first surface. The through-hole conductor is located on an inner wall of the through-hole and includes a portion where an opening area in cross section parallel to the second surface increases from the first surface side toward the second surface side.

## Description

### TECHNICAL FIELD

The present disclosure relates to a printed wiring board.

### BACKGROUND OF INVENTION

Techniques known in the related art use a waveguide extending in the thickness direction of a printed wiring board for transmitting a signal from one side of the printed wiring board to the other (see, for example, Japanese Unexamined Patent Application Publication No 2015-139042). A waveguide in the related art has no variation in diameter at each position in the thickness direction of the printed wiring board.

### SUMMARY

In an aspect of the present disclosure, a printed wiring board includes a first insulating layer and a through-hole conductor. The first insulating layer includes a through-hole passing through from a first surface of the first insulating layer to a second surface opposite the first surface. The through-hole conductor is located on an inner wall of the through-hole and includes a portion where an opening area in a cross section parallel to the second surface increases from the first surface side toward the second surface side.

### BRIEF DESCRIPTION OF THE DRAWINGS

FIG. 1 is a plan view and a sectional view of a printed wiring board according to a first embodiment.
FIG. 2 is a plan view of a printed wiring board according to a first variation.
FIG. 3 is a plan view of another printed wiring board according to the first variation.
FIG. 4 is a plan view of another printed wiring board according to the first variation.
FIG. 5 is a plan view of another printed wiring board according to the first variation.
FIG. 6 is a plan view of another printed wiring board according to the first variation.
FIG. 7 is a sectional view of a printed wiring board according to a second variation.
FIG. 8 is a sectional view of another printed wiring board according to the second variation.
FIG. 9 is a sectional view of a printed wiring board according to a second embodiment.
FIG. 10 is a plan view and a sectional view of a printed wiring board according to a third embodiment.
FIG. 11 is a sectional view of a printed wiring board according to a fourth embodiment.
FIG. 12 is a sectional view of a printed wiring board according to a fifth embodiment.
FIG. 13 is a sectional view of a printed wiring board according to a sixth embodiment.
FIG. 14 is a sectional view for explaining a method for manufacturing a printed wiring board.
FIG. 15 is a sectional view for explaining the method for manufacturing the printed wiring board.
FIG. 16 is a sectional view for explaining the method for manufacturing the printed wiring board.

### DESCRIPTION OF EMBODIMENTS

Embodiments will be described below with reference to the drawings. Note that, for convenience of description, each of the drawings referred to below illustrates only main members necessary for describing the embodiments in a simplified manner. Therefore, a printed wiring board 1 according to the present disclosure may include any constituent members that are not illustrated in the drawings referred to herein. Further, the dimensions of the members illustrated in the drawings do not faithfully reflect actual dimensions, dimensional ratios and/or the like of the constituent members.

### [First Embodiment]

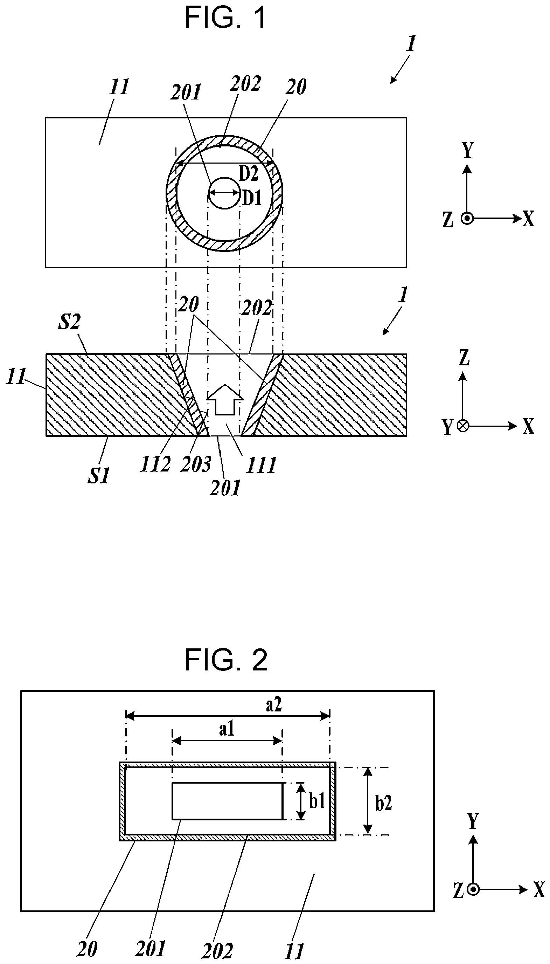

As illustrated in FIG. 1, a printed wiring board 1 according to a first embodiment includes a first insulating layer 11 and a through-hole conductor 20. Hereinafter, the orientation of each component of the printed wiring board 1 will be described using an XYZ orthogonal coordinate system with the thickness direction of the printed wiring board 1 as the Z direction. The surface facing the +Z direction of each layer constituting the printed wiring board 1 is also referred to as an "upper surface" and the surface facing the -Z direction is also referred to as a "lower surface". Also, viewing from the Z direction is referred to as "plan view".

The first insulating layer 11 is a plate-like member of insulating material. Hereinafter, the lower surface of the first insulating layer 11 is referred to as a first surface S1 and the upper surface (the surface opposite the first surface S1) is referred as a second surface S2. The first surface S1 and the second surface S2 are parallel to the XY plane. Hereinafter, a cross section parallel to the second surface S2 is referred to as a "transverse section" and a cross section perpendicular to the second surface S2 is referred to as a "longitudinal section".

The material of the first insulating layer 11 is not particularly limited as long as it has insulating properties. Examples of the material of the first insulating layer 11 include epoxy resin, bismaleimide-triazine resin, polyimide resin, polyphenylene ether (PPE) resin, phenol resin, polytetrafluoroethylene (PTFE) resin, silicon resin, polybutadiene resin, polyester resin, melamine resin, urea resin, polyphenylene sulfide (PPS) resin, and polyphenylene oxide (PPO) resin. Two or more of these resins may be used as a mixture. From the viewpoint of enhancing the strength of the printed wiring board 1, the first insulating layer 11 may also contain a fibrous base material such as glass cloth. The first insulating layer 11 may also contain an inorganic filler such as aluminum hydroxide, silica or barium sulfate, or an organic filler such as phenolic resin or methacrylic resin.

The first insulating layer 11 includes a through-hole 111 passing through from the first surface S1 to the second surface S2. An inner wall 112 of the through-hole 111 has a shape of the side face of a truncated cone. Thus, the shapes of the openings of the through-hole 111 in the first surface S1, in the second surface S2, and in any transverse section are all circular. The radius of the circle formed by these openings increases from the first surface S1 toward the second surface S2.

The through-hole conductor 20 is located on the inner wall 112 of the through-hole 111 and extends from the first surface S1 to the second surface S2 along the inner wall 112. The thickness of the through-hole conductor 20 is substantially uniform. Therefore, an inner wall 203 of the through-hole conductor 20 has a shape of the side face of a truncated cone, the same as, and/or similarly to, the inner wall 112 of the through-hole 111. In the through-hole conductor 20, a first surface side opening 201 on the first surface S1 and a second surface side opening 202 on the second surface S2 are not blocked by other conductors. The shapes of the first surface side opening 201, the second surface side opening 202, and the opening in any transverse section of the through-hole conductor 20 are all circular. The radius of the circle formed by these openings increases toward the second surface S2 over a range from the first surface S1 to the second surface S2. Therefore, the opening area of the through-hole conductor 20 in the transverse section increases toward the second surface S2 over a range from the first surface S1 to the second surface S2. In any longitudinal section through the central axis of the through-hole 111, the opening width of the through-hole conductor 20 in the direction parallel to the second surface S2 (the opening width in the X direction in FIG. 1) increases (i.e., the diameter expands) toward the second surface S2 over a range from the first surface S1 to the second surface S2. The through-hole conductor 20 includes a portion that is inclined with respect to a direction perpendicular to the second surface S2 (the Z direction) in any longitudinal section through the central axis of the through-hole 111. To be more specific, the through-hole conductor 20 includes a portion where the inner wall 203 is inclined with respect to the direction perpendicular to the second surface S2 in the above-described longitudinal section. In another point of view, the through-hole conductor 20 includes a portion where the area of the opening in the transverse section increases from the first surface S1 side toward the second surface S2 side. The through-hole conductor 20 may be, for example, a metal (plating layer) such as copper, nickel and/or gold formed on the inner wall 112 of the through-hole 111 by a plating process.

The through-hole conductor 20 functions as a waveguide propagating an electromagnetic wave from the first surface side opening 201 to the second surface side opening 202 as indicated by the void arrow in FIG 1. The through-hole conductor 20 as the waveguide propagates an electromagnetic wave of wavelength λ that satisfy both λ/2≤D1≤λ and λ/2≤D2≤λ when the diameter of the first surface side opening 201 is D1 and the diameter of the second surface side opening 202 is D2. By using such a waveguide, the electromagnetic wave can be transmitted in the +Z direction from the second surface side opening 202 of the printed wiring board 1. To be specific, if an output terminal of a monolithic microwave integrated circuit (MMIC) that outputs an electromagnetic wave such as a microwave or a connection pad electrically connected to the output terminal is disposed near the first surface side opening 201 as an electrode, the electromagnetic wave output from the electrode can be guided to the second surface S2 side by the through-hole conductor 20, so as to be transmitted in the +Z direction from the second surface side opening 202.

Also, an electromagnetic wave incident on the second surface side opening 202 from above the printed wiring board 1 can be guided by the through-hole conductor 20 to the first surface S1 side and incident on the above-described electrode from the first surface side opening 201 to be received.

Thus, with the configuration in which the opening area of the through-hole conductor 20 in the transverse section increases toward the second surface S2 side, when radiating an electromagnetic wave from the second surface S2 side, a waveguide (a feed-horn type waveguide) whose opening diameter increases as the electromagnetic wave travels in the propagation direction can be obtained. Therefore, inside the through-hole conductor 20, since the electromagnetic wave becomes close to a plane wave as it approaches the second surface S2, the change of the electromagnetic wave radiated outward from the second surface side opening 202 to a plane wave becomes gradual. Further, since the more the electromagnetic wave travels toward the second surface side opening 202, the larger the opening diameter of the through-hole conductor 20 becomes, reflection of the electromagnetic wave inside the through-hole conductor 20 is less likely to occur compared with a waveguide with a constant opening diameter. Thus, signal transmission gain is improved compared with a waveguide in the related art that has a constant opening diameter.

In addition, during reception, convergence efficiency of the electromagnetic wave incident on the through-hole conductor 20 from the second surface side opening 202 can be improved.

With the configuration in which the inner wall 203 of the through-hole conductor 20 is inclined with respect to the Z direction, during transmission, a region in which the electromagnetic wave traveling from the first surface S1 side toward the second surface S2 side gradually spreads is formed. Thus, reflection less likely occurs inside the through-hole conductor 20, so that signal transmission gain is further improved.

In addition, during reception, the convergence efficiency of the electromagnetic wave incident on the through-hole conductor 20 from the second surface side opening 202 can be further improved.

In other words, the printed wiring board 1 according to the present embodiment includes a first insulating layer, a through-hole conductor and a through-hole, in which the first insulating layer includes a first surface and a second surface opposite the first surface; the through-hole conductor is located across the first surface and the second surface, and the area surrounded by the through-hole conductor is the through-hole; and the through-hole includes a portion where the area of the opening in a cross section parallel to the second surface increases from the first surface toward the second surface.

### [First Variation]

A first variation of the first embodiment will be described. The printed wiring board 1 according to the first variation differs from that according to the above-described embodiment in that it has a shape in which the aspect ratio of the opening of the through-hole conductor 20 in a transverse section exceeds 1. Hereinafter, points different from the first embodiment will be described, and the points in common with the first embodiment will not be described again. The first variation may be combined with any one of second to sixth embodiments to be described below.

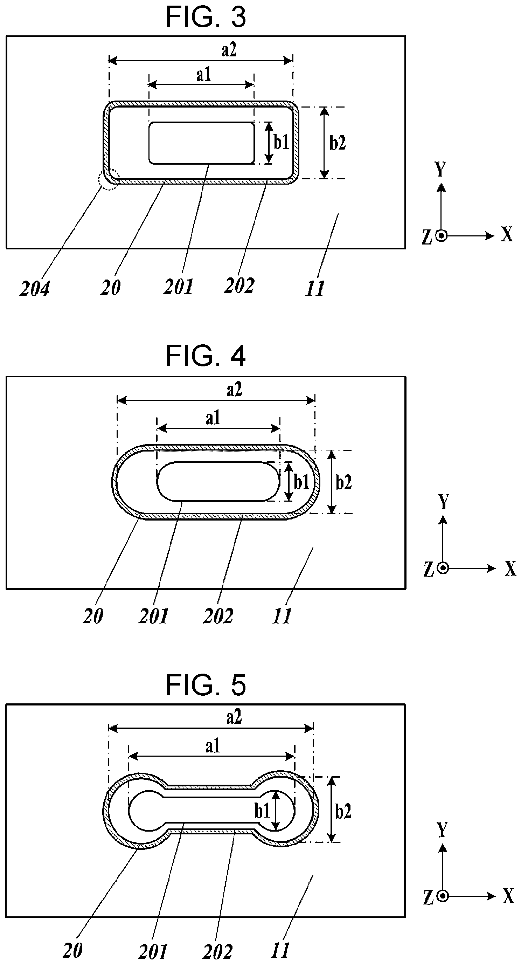

As illustrated in FIG. 2, in a through-hole conductor 20 of a printed wiring board 1 according to the first variation, the shapes of a first surface side opening 201, a second surface side opening 202, and the opening in any transverse section are rectangles similar to each other. These rectangles increase in area from a first surface S1 toward a second surface S2. In any longitudinal section through the central axis of a through-hole 111, an inner wall 203 is inclined with respect to a direction perpendicular to the second surface S2 (the Z direction). Here, when the opening of the through-hole conductor 20 has a shape other than circular, the central axis of the through-hole 111 can be, for example, the axis passing through the center of gravity of the opening shape in a transverse section (the same goes for FIGs. 3 to 6 below).

Note that the portion of the inner wall 203 that is inclined with respect to the Z direction may be either on the inner wall in the longitudinal direction (the inner wall parallel to the X direction) or on the inner wall in the transverse direction (the inner wall parallel to the Y direction) of the through-hole conductor 20. In particular, such portion is preferably on the inner wall in the longitudinal direction.

The length of the long side (the major diameter) of the first surface side opening 201 is a1 and the length of the short side (the minor diameter) of the first surface side opening 201 is b 1. The length of the long side of the second surface side opening 202 is a2 and the length of the short side of the second surface side opening 202 is b2. The through-hole conductor 20 in FIG. 2 propagates an electromagnetic wave of wavelength λ that satisfies both λ/2≤a1≤λ and λ/2≤a2≤λ.

With such a configuration, the range of wavelengths of the electromagnetic wave possible to pass through can be widened by the amount that the major diameter of the through-hole conductor 20 is larger than the minor diameter. Since the short diameter is relatively small, it becomes easier for the electromagnetic field of the plane wave propagating through the waveguide to be oriented toward the major diameter (the X direction in FIG. 2), so that propagation efficiency can be improved.

As illustrated in FIG. 3, the shape of the opening of the through-hole conductor 20 in a transverse section may be a rectangular shape with curved corner portions 204. In other words, the corner portions 204 of the inner wall of the through-hole conductor 20 may be curved in concave shape.

With such a configuration, during transmission and reception of signals, the magnetic field (magnetic field lines) circulating around the current propagating in the Z direction through the through-hole conductor 20 is less likely to be reflected by the inner wall near the corner portions 204. Thus, signal transmission gain can be improved.

The shape of the opening of the through-hole conductor 20 in a transverse section is not limited to the rectangular shapes illustrated in FIG. 2 and FIG. 3, but can be any shape with an aspect ratio exceeding 1.

For example, as illustrated in FIG. 4, the opening of the through-hole conductor 20 in a transverse section may have a racetrack shape (an elongated circle extending in the X direction).

Also, as illustrated in FIG. 5, the opening of the through-hole conductor 20 in a transverse section may have a dumbbell shape. Here, the dumbbell shape is such that both one end portion and the other end portion in the X direction are circular and a central portion of the dumbbell shape other than the both end portions is strip-shaped. In other words, the dumbbell shape is a shape in which two circular end portions are connected by a strip-shaped central portion whose width is narrower than the diameter of the circular shape.

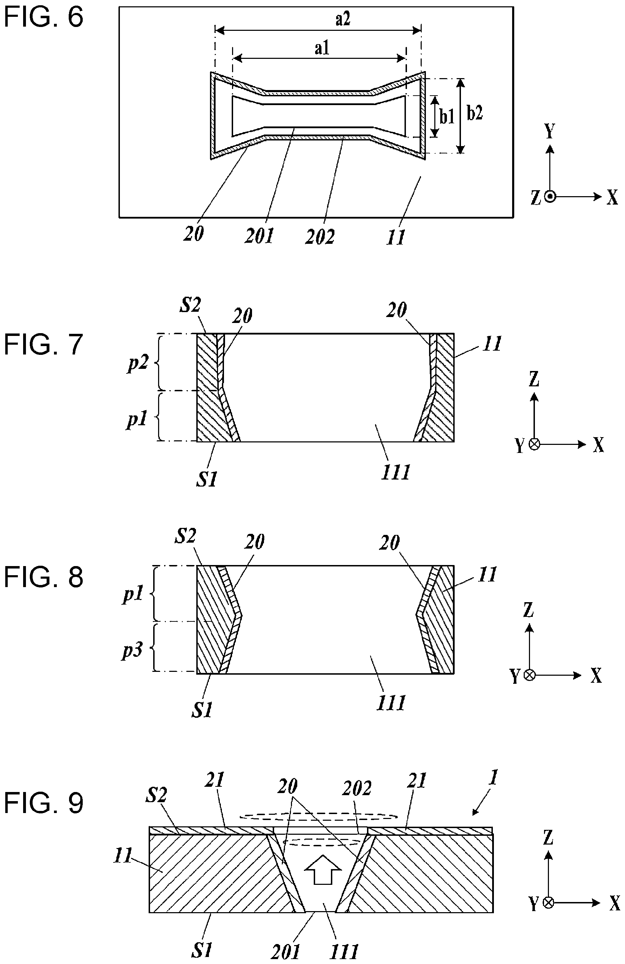

As illustrated in FIG. 6, the opening of the through-hole conductor 20 in a transverse section may have a bow-tie shape. Here, the bow-tie shape is such that both one end portion and the other end portion in the X direction are trapezoidal, and a central portion of the bow-tie shape other than the both end portions is strip-shaped. The trapezoidal shape of each end portion is such that the width of each end portion in the Y direction becomes wider gradually as it goes closer to the end in the X direction.

These racetrack-shaped, dumbbell-shaped, and bow-tie-shaped through-hole conductors 20 also have effects same as, and/or similar to, those of the rectangular through-hole conductor 20.

### [Second Variation]

A second variation of the first embodiment will be described. The printed wiring board 1 according to the second variation differs from that according to the above-described embodiment in the shape of the through-hole conductor 20 in a longitudinal section. Hereinafter, points different from the first embodiment will be described, and the points in common with the first embodiment will not be described again. The second variation may be combined with the first variation. The second variation may also be combined with any one of the second to sixth embodiments to be described below.

As illustrated in FIG. 7, a through-hole conductor 20 of the printed wiring board 1 according to the second variation includes a portion p1 where the area of the opening in the transverse section increases toward a second surface S2 and a portion p2 where the area of the opening in the transverse section remains constant. The portion p1 is a portion of the through-hole conductor 20 within a predetermined distance range from the first surface S1, and the portion p2 is a portion of the through-hole conductor 20 excluding the portion p1.

In another point of view, in any longitudinal section through the central axis of a through-hole 111, in the portion p1, the opening width in a direction parallel to the second surface S2 increases toward the second surface S2. On the other hand, in any longitudinal section, in the portion p2, the opening width in a direction parallel to the second surface S2 is constant.

In another point of view, in any longitudinal section through the central axis of the through-hole 111, in the portion p1, an inner wall 203 is inclined with respect to a direction perpendicular to the second surface S2 (the Z direction). On the other hand, in any cross section, in the portion p2, the inner wall surface is parallel to the Z direction.

Note that the configuration may also be such that the portion p2 where the area of the opening is constant is on the first surface S1 side and the portion p1 where the area of the opening increases is on the second surface S2 side.

Thus, the through-hole conductor 20 only needs to include a portion where the area of the opening in the transverse section increases from the first surface S1 side toward the second surface S2 side, and the area of the opening in the transverse section only needs to be monotonically non-decreasing toward the second surface S2.

As illustrated in FIG. 8, the through-hole conductor 20 of the printed wiring board 1 according to the second variation may include a portion p3 where the area of the opening in the transverse section decreases toward the second surface S2 and a portion p1 where the area of the opening in the transverse section increases toward the second surface S2. The portion p3 is a portion of the through-hole conductor 20 within a predetermined distance range from the first surface S1, and the portion p1 is a portion of the through-hole conductor 20 excluding the portion p3.

With the configuration in FIG. 8, since reflection and convergence during transmission and reception can be averaged, the difference in signal propagation efficiency during transmission and reception can be reduced.

### [Second Embodiment]

A second embodiment will be described. A printed wiring board 1 according to the second embodiment differs from that according to the first embodiment in that it includes a first conductor layer 21. Hereinafter, points different from the first embodiment will be described, and the points in common with the first embodiment will not be described again.

As illustrated in FIG. 9, the printed wiring board 1 according to the second embodiment includes the first conductor layer 21 provided on a second surface S2 of a first insulating layer 11. The first conductor layer 21 is electrically connected to a through-hole conductor 20. The first conductor layer 21 is disposed in a manner such that the size of a second surface side opening 202 of the through-hole conductor 20 is maintained. In other words, the first conductor layer 21 is disposed so that the second surface side opening 202 is not blocked. The first conductor layer 21 may be provided only on a portion of the second surface S2, for example, around a connection portion with the through-hole conductor 20.

The first conductor layer 21 may be, for example, a plating layer (such as copper, nickel or gold) formed by a plating process, a metallic foil such as copper foil, a vapor-deposited film, a sputtered film or the like. Among these options, the copper plating layer and/or the copper foil are preferable from the point of view of cost and mass production.

Note that, in the printed wiring board 1, the first conductor layer 21 electrically connected to the through-hole conductor 20 may also be provided on the second surface S2. A printed board with single-sided or double-sided copper foil may be used as the first insulating layer 11 with the first conductor layer 21.

Thus, with the configuration in which the first conductor layer 21 provided on the second surface S2, during transmission, when an electromagnetic wave is radiated from the second surface S2 side through the through-hole conductor 20, the electromagnetic wave (electromagnetic field) spreads along the first conductor layer 21 provided on the second surface S2, as indicated by the dashed line in FIG. 9. This enables the electromagnetic field radiated from the second surface S2 side through the through-hole conductor 20 to be changed into a wider and more stable plane wave. Thus, efficiency of emitting the electromagnetic wave into space can be improved.

In addition, during reception, convergence efficiency of the received plane wave can be improved.

### [Third Embodiment]

A third embodiment will be described. A printed wiring board 1 according to the third embodiment differs from that according to the second embodiment in that it includes an organic resin 40, a second insulating layer 12, and a plurality of first via conductors 31. Hereinafter, points different from the second embodiment will be described, and the points in common with the second embodiment will not be described again.

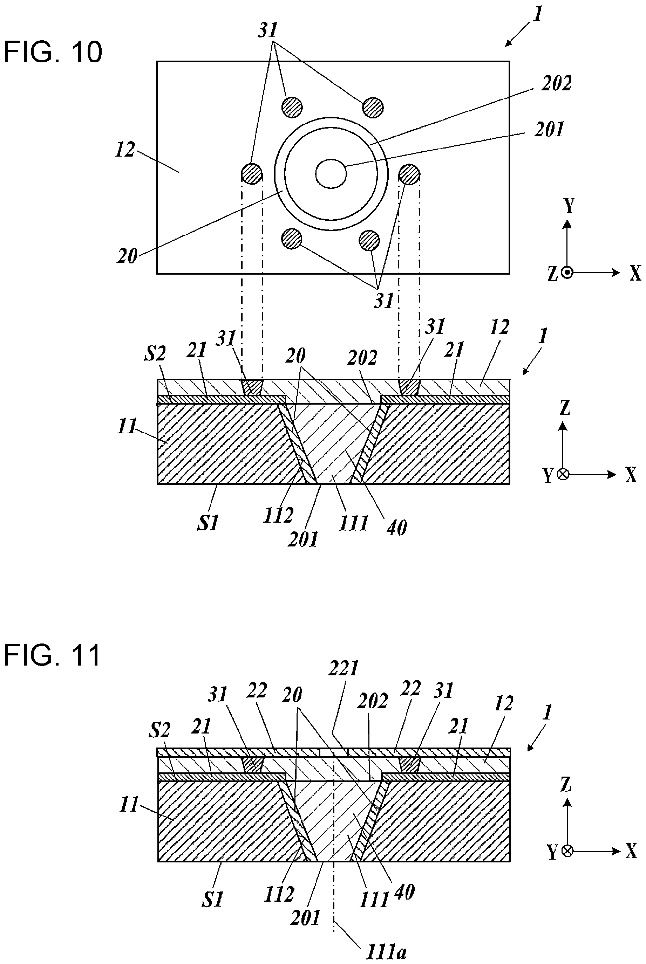

As illustrated in FIG. 10, the printed wiring board 1 according to the third embodiment includes the organic resin 40 (resin) filling a space surrounded by a through-hole conductor 20, the second insulating layer 12 provided on a first conductor layer 21, and the plurality of via conductors 31 passing through the second insulating layer 12. Here, the space surrounded by the through-hole conductor 20 means a space surrounded by the inner wall of the through-hole conductor 20, the surface formed by a first surface side opening 201, and the surface formed by a second surface side opening 202. The plurality of via conductors 31 is electrically connected to the first conductor layer 21. The plurality of via conductors 31 is disposed outside the second surface side opening 202 so as to surround the second surface side opening 202 in plan view toward a second surface S2. In FIG. 10, there are six via conductors 31 that are equally spaced around the second surface side opening 202. The material of the via conductors 31 may be any of those exemplified above as the material of the first conductor layer 21, or may be the same as the material of the first conductor layer 21.

At least one selected from epoxy resin (relative permittivity ε: 2.5 to 6.0), polyimide resin (relative permittivity ε: 4.8 to 4.9), polyamide resin (relative permittivity ε: 3.8 to 4.1), polyphenylene ether resin (relative permittivity ε: 2.8 to 2.9) and the like may be used as the organic resin 40 to fill the through-hole 111 (the through-hole conductor 20). The organic resin 40 may be mixed with an inorganic filler.

Liquid crystal polymer (relative permittivity ε: 3.5 to 3.6), PTFE (polytetrafluoroethylene, relative permittivity ε: 2.1), cyclic olefin copolymer (relative permittivity: 2.7) or the like may be used as the second insulating layer 12. In particular, the second insulating layer 12 preferably has a lower relative permittivity than the organic resin 40. The relative permittivity of the second insulating layer 12 and/or the organic resin 40 may be adjusted by changing the porosity or changing the inorganic filler content of the second insulating layer 12 and/or the organic resin 40. In particular, epoxy resin may be used for the organic resin 40 and liquid crystal polymer may be used for the second insulating layer 12. Note that the same material as the organic resin 40 may be used as the second insulating layer 12.

With the configuration in which the plurality of via conductors 31 is provided, during transmission, after the electromagnetic wave reaches the first conductor layer 21 from the through-hole conductor 20, its spread as a plane wave can be suppressed by the via conductors 31 while improving directivity. Further, during reception, convergence efficiency of the plane wave can be improved.

Further, since the relative permittivity of the second insulating layer 12 is lower than the relative permittivity of the organic resin 40, cutoff frequency can be increased during transmission when the electromagnetic wave is radiated from the through-hole conductor 20 toward the first conductor layer 21, so that higher-order mode electromagnetic waves can be more attenuated. In the second insulating layer 12 with low relative permittivity, the range of the wavelengths of the electromagnetic wave during emission can be broadened.

### [Fourth Embodiment]

A fourth embodiment will be described. A printed wiring board 1 according to the fourth embodiment differs from that according to the third embodiment in that it includes a second conductor layer 22. Hereinafter, points different from the third embodiment will be described, and the points in common with the third embodiment will not be described again.

As illustrated in FIG. 11, the printed wiring board 1 according to the fourth embodiment includes the second conductor layer 22 provided on a second insulating layer 12. The second conductor layer 22 is electrically connected to a plurality of via conductors 31. The second conductor layer 22 includes, at a position surrounding a central axis 111a of a through-hole 111 in plan view, an opening 221 that is smaller in area than a second surface side opening 202. The shape of the opening 221 may be circular, for example. The shape of the opening 221 may be similar to the shape of the second surface side opening 202. The material of the second conductor layer 22 may be any of those exemplified above as the material of the first conductor layer 21, or may be the same as the material of the first conductor layer 21. The second conductor layer 22 and the via conductors 31 may be integral by being formed in a common process, such as plating process.

With such a configuration, during transmission, the directivity of the electromagnetic wave radiated in the +Z direction from the through-hole conductor 20 through the opening 221 can be improved by the via conductors 31 and the opening 221 of the second conductor layer 22, while improving convergence efficiency. Further, during reception, since the side lobe portion of the electromagnetic wave can be reduced by passing the electromagnetic wave through the opening 221 of the second conductor layer 22, the main lobe of the electromagnetic wave can be introduced into the through-hole conductor 20 with high efficiency. In such a case, inside the through-hole conductor 20, the plane wave tends to be oriented in a direction perpendicular to the direction in which electromagnetic wave travels (i.e., the direction parallel to the second surface S2). Further, higher-order mode electromagnetic waves can be attenuated.

### [Fifth Embodiment]

A fifth embodiment will be described. A printed wiring board 1 according to the fifth embodiment is equivalent to one obtained by adding components on the upper surface and the lower surface of the printed wiring board 1 according to the fourth embodiment. Hereinafter, points different from the fourth embodiment will be described, and the points in common with the fourth embodiment will not be described again.

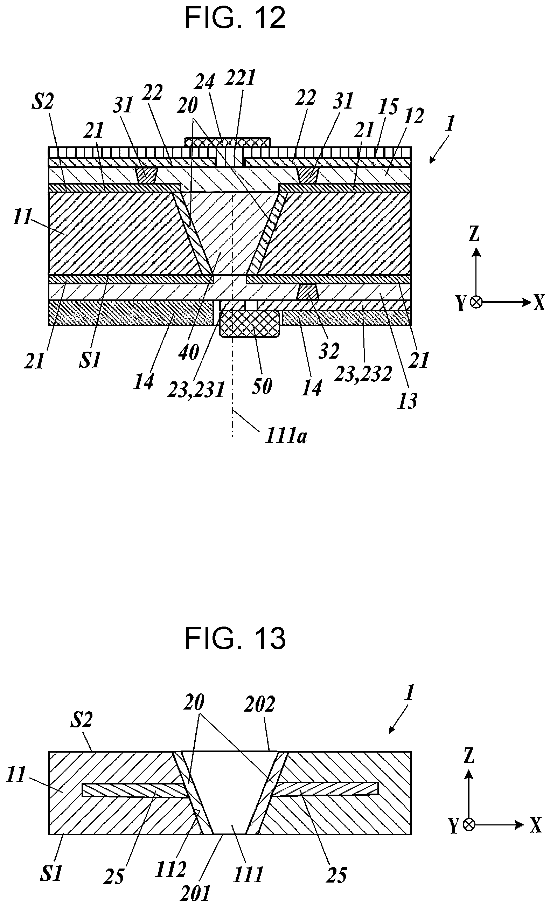

As illustrated in FIG. 12, in the printed wiring board 1 according to the fifth embodiment, a first conductor layer 21 electrically connected to a through-hole conductor 20 is also provided on a first surface S1 (the lower surface) of a first insulating layer 11. A third insulating layer 13 is provided on the lower surface of the first conductor layer 21 on the first surface S1 to cover a first surface side opening 201 of the through-hole conductor 20. A third conductor layer 23 is provided on (the lower surface of) the third insulating layer 13. The third conductor layer 23 includes a plurality of connection pads 231 and 232 (connection portions) that is electrically connected to the terminals of an MMIC 50 as an electronic component. The connection pad 231 overlaps a central axis 111a of a through-hole 111 in plan view toward the first surface S 1. In other words, the position of the connection pad 231 overlaps the central axis 111a. The connection pad 232 is electrically connected to the first conductor layer 21 on the first surface S1 by a via conductor 32 passing through the third insulating layer 13. A fourth insulating layer 14 is provided on the lower surface of the third insulating layer 13 and the lower surface of the third conductor layer 23.

The material of the third insulating layer 13 and the fourth insulating layer 14 may be any of those exemplified above as the material of the second insulating layer 12, or may be the same as the material of the second insulating layer 12. The material of the via conductor 32 and the third conductor layer 23 may be any of those exemplified above as the material of the first conductor layer 21, or may be the same as the material of the first conductor layer 21. The via conductor 32 and the third conductor layer 23 may be integral by being formed in a common process, such as plating process.

A fifth insulating layer 15 is provided on the upper surface of a second conductor layer 22 to cover an opening 221 of the second conductor layer 22. A fourth conductor layer 24 is provided on the upper surface of the fifth insulating layer 15 in a range covering the opening 221 in plan view. The fourth conductor layer 24 functions as a patch antenna.

The material of the fifth insulating layer 15 may be any of those exemplified above as the material of the second insulating layer 12, or may be the same as the material of the second insulating layer 12. However, the relative permittivity of the second insulating layer 12 is preferably lower than the relative permittivity of an organic resin 40, and the relative permittivity of the fifth insulating layer 15 is preferably lower than the relative permittivity of the second insulating layer 12. In particular, epoxy resin may be used for the organic resin 40, liquid crystal polymer may be used for the second insulating layer 12, and PTFE may be used for the fifth insulating layer 15.

The material of the fourth conductor layer 24 may be any of those exemplified above as the material of the first conductor layer 21, or may be the same as the material of the first conductor layer 21.

With such a configuration, an electromagnetic wave (a high-frequency signal) radiated from the terminals of the MMIC 50 can be guided from the connection pad 231 to the through-hole conductor 20 and transmitted in the +Z direction from the fourth conductor layer 24. Here, since the connection pad 231 is on the central axis 111a of the through-hole 111, the electromagnetic wave radiated from the terminals of the MMIC 50 can be propagated linearly through the narrow through-hole conductor 20. Thus, transmission loss of the electromagnetic wave when entering from the MMIC 50 to the through-hole conductor 20 can be reduced.

In addition, during reception, the electromagnetic wave from the fourth conductor layer 24 as a patch antenna through the through-hole conductor 20 can be transmitted to the MMIC 50 with a high convergence rate.

### [Sixth Embodiment]

A sixth embodiment will be described. A printed wiring board 1 according to the sixth embodiment differs from that according to the first embodiment in that it includes an inner layer conductor 25 inside a first insulating layer 11. Hereinafter, points different from the first embodiment will be described, and the points in common with the first embodiment will not be described again.

As illustrated in FIG. 13, the printed wiring board 1 according to the sixth embodiment includes the inner layer conductor 25 inside the first insulating layer 11. The inner layer conductor 25 is electrically connected to a through-hole conductor 20. The inner layer conductor 25 is a plate-shaped conductor parallel to a second surface S2. The first insulating layer 11 may consist of a plurality of insulators stacked in the Z direction, and the inner layer conductor 25 may be formed at any one of the interfaces of the plurality of insulators. There may be a plurality of layers of inner layer conductors 25.

The sixth embodiment may be combined with any one of the second to fifth embodiments. In other words, the printed wiring board 1 of any one of the second to fifth embodiments may include an inner layer conductor 25 inside the first insulating layer 11.

With the configuration in which the inner layer conductor 25 is provided, deformation of the waveguide including the through-hole conductor 20 can be reduced when the first insulating layer 11 is subjected to a load that may cause bending or the like. Thus, disturbance of the electromagnetic wave being propagated can be reduced, and therefore stable transmission gain (transmission efficiency) can be achieved.

### [Method for Manufacturing Printed Wiring Board]

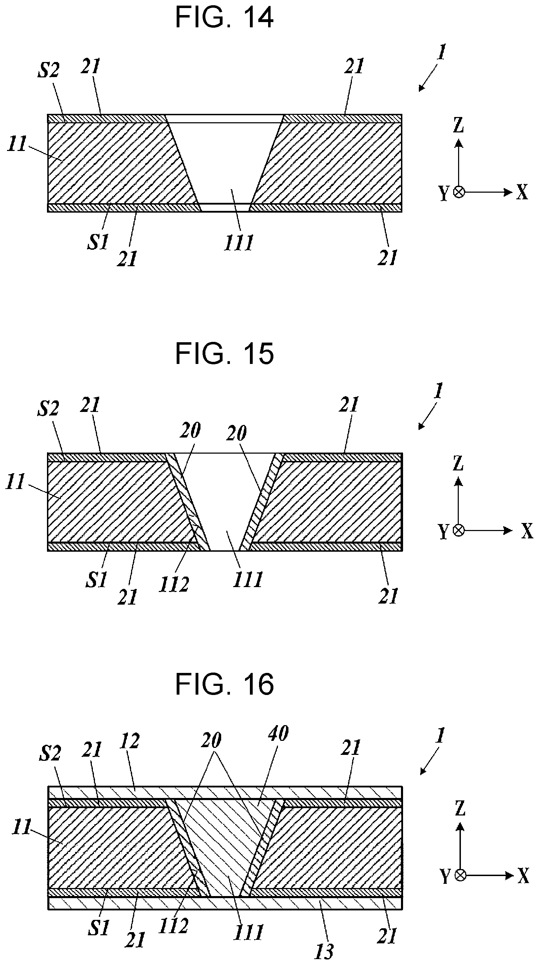

An example of a method for manufacturing a printed wiring board 1 will be described below with reference to FIGs. 14 to 16. Here, the method will be described using an example in which the printed wiring board 1 according to the fifth embodiment illustrated in Fig. 12 is to be manufactured. The materials of each component listed in the following manufacturing method are examples, to which the present disclosure is not limited.

First, a printed board having the first insulating layer 11 and the first conductor layer 21 formed on the first surface S1 and second surface S2 of the first insulating layer 11 is prepared. The first insulating layer 11 is, for example, epoxy resin impregnated glass cloth (relative permittivity ε: 4.6), and the first conductor layer 21 is copper foil.

Then, as illustrated in FIG. 14, the through-hole 111 is formed in the printed board by using a reamer-type drill whose tip end has a diameter smaller than the rear end. For forming a rectangular or other angled shape, a drill with a smaller diameter is used in combination. By using a reamer-type drill, a through-hole 111 whose opening area increases toward the second surface S2 can be formed.

Then, as illustrated in FIG. 15, an electroless copper plating process and an electrolytic copper plating process are performed to form the through-hole conductor 20 on the inner wall 112 of the through-hole 111. Note that the first conductor layer 21 may also be formed in this step.

Then, as illustrated in FIG. 16, the space surrounded by the through-hole conductor 20 is filled with the organic resin 40 of epoxy resin (relative permittivity ε: 4.3). A liquid crystal polymer (relative permittivity ε: 3.5 to 3.6) is laid up on the first surface S1 side and the second surface S2 side of the structure filled with the organic resin 40, and the structure in this state is heated and pressurized in the Z direction (for example, 2 hours at 200°C). Thus, the liquid crystal polymer is melt once and then cured to form the second insulating layer 12 on the second surface S2 side and form the third insulating layer 13 on the first surface S1 side, as illustrated in FIG. 16. Thereafter, by using a known film forming technique and the like, the via conductors 31, the second conductor layer 22, the fifth insulating layer 15, and the fourth conductor layer 24 are formed on the second surface S2 side, and the via conductor 32, the third conductor layer 23, the fourth insulating layer 14, and the MMIC 50 are formed on the first surface S1 side to complete the printed wiring board 1 illustrated in FIG. 12.

Note that the specific details of the configuration, structure, positional relationship, and shape illustrated in the above-described embodiments can be appropriately modified without departing from the scope of the present disclosure. Further, the configuration, structure, positional relationship, and shape illustrated in the above-described embodiments can be appropriately combined without departing from the scope of the present disclosure.

### INDUSTRIAL AVAILABILITY

The present disclosure can be used in a printed wiring board.

### REFERENCE SIGNS

1 printed wiring board
10 insulating layer
11 first insulating layer
111 through-hole
111a central axis
112 inner wall
12 second insulating layer
13 third insulating layer
14 fourth insulating layer
15 fifth insulating layer
20 through-hole conductor
201 first surface side opening
202 second surface side opening
203 inner wall
204 corner portion
21 first conductor layer
22 second conductor layer
221 opening
23 third conductor layer
231, 232 connection pad (connection portion)
24 fourth conductor layer
25 inner layer conductor
31, 32 via conductor
40 organic resin (resin)
50 MMIC (electronic component)
S1 first surface
S2 second surface

## Claims

1. A printed wiring board comprising:
a first insulating layer; and
a through-hole conductor,
wherein
the first insulating layer includes a through-hole passing through from a first surface of the first insulating layer to a second surface opposite the first surface, and
the through-hole conductor is located on an inner wall of the through-hole and includes a portion where an opening area in a cross section parallel to the second surface increases from a side of the first surface toward a side of the second surface.

2. The printed wiring board according to claim 1, wherein the opening area of the through-hole conductor increases toward the second surface over a range from the first surface to the second surface.

3. The printed wiring board according to claim 1, wherein an opening width of the through-hole conductor in a direction parallel to the second surface increases, in any cross section passing through a central axis of the through-hole and perpendicular to the second surface, toward the second surface over a range from the first surface to the second surface.

4. The printed wiring board according to any one of claims 1 to 3, wherein the through-hole conductor includes a portion that is inclined with respect to a direction perpendicular to the second surface in any cross section passing through a central axis of the through-hole and perpendicular to the second surface.

5. The printed wiring board according to any one of claims 1 to 4, wherein the through-hole conductor is shaped such that an aspect ratio of an opening in the cross section parallel to the second surface exceeds 1.

6. The printed wiring board according to claim 5, wherein a shape of the opening of the through-hole conductor in the cross section parallel to the second surface is a rectangular shape, a racetrack shape, a dumbbell shape or a bow-tie shape.

7. The printed wiring board according to claim 5, wherein a shape of the opening of the through-hole conductor in the cross section parallel to the second surface is a rectangular shape with a curved corner portion.

8. The printed wiring board according to any one of claims 1 to 7, further comprising:
a first conductor layer provided on the second surface of the first insulating layer and electrically connected to the through-hole conductor.

9. The printed wiring board according to claim 8 further comprising:
a resin filling a space surrounded by the through-hole conductor;
a second insulating layer provided on the first conductor layer; and
a plurality of via conductors passing through the second insulating layer,
wherein
the plurality of via conductors is electrically connected to the first conductor layer and is disposed to surround, in plan view toward the second surface, a second surface side opening of the through-hole conductor on the second surface.

10. The printed wiring board according to claim 9, wherein a relative permittivity of the second insulating layer is lower than a relative permittivity of the resin.

11. The printed wiring board according to claim 9 or claim 10, further comprising:
a second conductor layer provided on the second insulating layer,
wherein
the second conductor layer is electrically connected to the plurality of via conductors, and
the second conductor layer includes an opening at a position surrounding a central axis of the through-hole in the plan view, the opening being smaller in area than the second surface side opening.

12. The printed wiring board according to claim 11, further comprising:
a third insulating layer covering a first surface side opening of the through-hole conductor on the first surface; and
a third conductor layer provided on the third insulating layer,
wherein
the third conductor layer includes a plurality of connection portions that is electrically connected to an electronic component, and
at least one of the plurality of connection portions overlaps the central axis of the through-hole in plan view toward the first surface.

13. The printed wiring board according to any one of claims 1 to 12, further comprising:
an inner layer conductor inside the first insulating layer,
wherein
the inner layer conductor is electrically connected to the through-hole conductor.
